## Europäisches Patentamt
## European Patent Office
## Office européen des brevets

(19)

(11) Numéro de publication: **0 059 206**
**B1**

(12) **FASCICULE DE BREVET EUROPEEN**

(45) Date de publication du fascicule du brevet:
**31.07.85**

(51) Int. Cl.⁴: **H 05 K 3/12,** H 05 K 1/03, H 05 K 3/36, H 05 K 3/46

(21) Numéro de dépôt: **81902466.2**

(22) Date de dépôt: **28.08.81**

(86) Numéro de dépôt international:
**PCT/FR 81/00109**

(87) Numéro de publication internationale:
**WO 82/00938 (18.03.82** Gazette 82/8)

(54) **CIRCUIT IMPRIME ET SON PROCEDE DE FABRICATION.**

(30) Priorité: **09.09.80 FR 8019462**

(43) Date de publication de la demande:
**08.09.82 Bulletin 82/36**

(45) Mention de la délivrance du brevet:
**31.07.85 Bulletin 85/31**

(84) Etats contractants désignés:
**CH DE GB LI NL SE**

(56) Documents cités:
**DE - A - 2 724 399**
**DE - A - 2 831 984**
**FR - A - 2 167 939**
**FR - A - 2 402 379**
**GB - A - 1 565 207**

(73) Titulaire: **SERRAS-PAULET, Edouard, Casa Nostra - Pech des Treilles, F-82240 Puylaroque (FR)**

(72) Inventeur: **SERRAS-PAULET, Edouard, Casa Nostra - Pech des Treilles, F-82240 Puylaroque (FR)**

(74) Mandataire: **Ramey, Daniel et al, Cabinet NETTER 40, rue Vignon, F-75009 Paris (FR)**

## Description

L'invention concerne un circuit électrique imprimé du type à au moins deux réseaux conducteurs croisés ou, superposés, séparés par un diélectrique et sou procédé de fabrication selon les premières parties des revendications 1, 7 et 11.

On connaît bien les circuits imprimés classiques à »simple face« ou »double face« qui comprennent un support diélectrique, en général de verre ou de résine époxy, revêtu sur une ou sur ses deux grandes faces d'une couche mince de cuivre dont la majeure partie est éliminée ensuite pour ne laisser subsister qu'un réseau de pistes conductrices et de plots ou plages de contact en cuivre sur une ou sur les deux faces du support.

Ces circuits imprimés ont pour inconvénients essentiels d'être d'un prix de revient élevé en raison de la complexité de leur procédé de fabrication et de l'élimination de la plus grande partie du cuivre dont les supports sont initialement revêtus, et d'être en général rigides et épais. De plus, les plots ou plages de contact en cuivre doivent subir un traitement supplémentaire pour résister à l'oxydation.

On connaît également des circuits imprimés souples, obtenus par le même procédé et qui ne diffèrent des précédents que par la nature du support qui peut être une feuille de matériau souple diélectrique. Toutefois, les pistes de cuivre que comportent ces circuits sont cassantes et se brisent par pliage ou à la suite d'une flexion importante. Ils sont également d'un coût élevé.

Pour pallier ces inconvénients, on a développé récemment une technique de fabrication de circuits imprimés, souples ou rigides, qui consiste à déposer par sérigraphie une encre conductrice sur un support diélectrique pour former un réseau conducteur sur une face de ce support. Après dépôt sur le support, l'encre est polymérisée par chauffage. On obtient ainsi des circuits imprimés dont le prix de revient est très inférieur à ceux des circuits imprimés classiques à pistes de cuivre et dont les pistes conductrices formées par l'encre polymérisée ne se brisent pas par pliage.

Toutefois, ce procédé ne convient actuellement qu'à la fabrication des circuits à un seul réseau conducteur. De nambreuses tentatives ont été faites pour obtenir de tels circuits imprimés comprenant deux réseaux conducteurs croisés ou superposés, qui sont isolés électriquement l'un de l'autre en certains points de connexion. Elles consistent, dans leur principe, à déposer par sérigraphie sur le support une première couche d'encre conductrice pour former un premier réseau, à polymériser cette couche pour la sécher et la durcir, à déposer ensuite par sérigraphie sur certaines parties du premier réseau une couche d'encre isolante ou diélectrique et à la polymériser pour la durcir et la sècher, à déposer ensuite par sérigraphie une seconde couche d'encre conductrice sur le support et sur certaines parties du premier réseau et de la couche d'encre diélectrique, et à polymériser par chauffage cette seconde couche d'encre conductrice. On obtient ainsi un second réseau conducteur isolé du premier en certaines zones par la couche intermédiaire d'encre diélectrique et relié au premier réseau par les zones où la seconde couche d'encre conductrice a été déposée directement sur la première couche d'encre conductrice.

On a constaté que les circuits ainsi obtenus présentent des inconvénients extrêmement importants:

— les particules conductrices que contiennent les couches d'encre conductrices migrent à travers la couche d'encre diélectrique et établissent des courts-circuits entre les deux réseaux conducteurs;

— la couche d'encre diélectrique devient cassante par polymérisation et se brise par pliage ou par flexion importante, ce qui entraîne la rupture des pistes conductrices sousjacentes du premier réseau;

— les encres isolantes présentent un retrait important au chauffage, qui entraîne la coupure des pistes conductrices supérieures;

— le chauffage de l'encre isolante pour sa polymérisation s'accompagne souvent d'une formation de bulles qui rendent impossible le dépôt de la seconde couche d'encre conductrice;

— les encres isolantes adhèrent mal à certains supports tels par exemple qu'une feuille de polyester;

— l'épaisseur de la couche d'encre isolante doit être très supérieure à celle d'une couche d'encre conductrice, d'où la formation par l'encre isolante de ressauts ou de saillies sur le support et le premier réseau conducteur. Les pistes conductrices du second réseau, déposées sur ces ressauts ou saillies, présentent des criques et/ou des micro-fissures et ne résistent pas au pliage;

— l'épaisseur de la couche d'encre isolante diminue lors du chauffage de polymérisation et, dans les zones où elle n'est pas très importante, laisse apparaître des micro-points de la première couche d'encre conductrice, d'où des courts-circuits entre les deux réseaux conducteurs;

— la capacité diélectrique de la couche d'encre isolante n'est pas constante sur tout le circuit, en raison des variations d'épaisseur de cette couche;

— les résultats obtenus par utilisation de mêmes encres ne sont pas reproductibles.

Du document GB-A-1 565 207 il est comme un circuit imprimé comprenant un support diélectrique sur les deux faces duquel'sont formés des réseaux conducteurs reliés entre eux par des trous remplis d'une substance fluide élastomère chargée de particules conductrices.

Le but essentiel de l'invention est d'éliminer ces inconvénients.

Elle a pour objet un circuit imprimé à au moins deux réseaux conducteurs croisés ou superposés formés par dépôt par sérigraphie d'encre(s) conductrice(s), ce circuit étant exempt des défauts précités et pouvant être réalisé à un prix de revient qui est trois ou quatre fois inférieur à celui d'un circuit équivalent obtenu par les procédés sérigraphiques connus.

Elle propose à cet effet un circuit imprimé comprenant un support diélectrique et au moins deux réseaux électriquement conducteurs portés par le support, ces réseaux étant croisés ou superposés et électriquement isolés l'un de l'autre à l'exception de certains points d'interconnexion où ils sont reliés à travers de trous due support, caractérisé en ce que lesdits réseaux comprennent chacun des pistes d'encre conductrice polymérisée qui sont formées respectivement de part et d'autre du support de manière à être électriquement isolées les unes des autres par ledit support, les connexions entre les réseaux étant établies par une couche d'épaisseur uniforme d'encre conductrice polymérisée déposée sur les parois des trous.

Ainsi, selon l'invention, les deux réseaux conducteurs du circuit imprimé sont séparés parfaitement l'un de l'autre par le support du circuit, qui est d'épaisseur constante, qui est à surface plane et que les particules conductrices des encres ne peuvent traverser par migration.

Selon une autre caractéristique de l'invention, les connexions entre les réseaux sont des trous traversant le support et dont les parois sont au moins partiellement recouvertes d'une couche uniforme d'encre conductrice.

On obtient ainsi très facilement les connexions voulues entre les deux réseaux conducteurs au moyen de trous traversant le support et à parois recouvertes au moins partiellement d'un film d'encre conductrice, qui établissent entre les réseaux des connexions homogènes et fiables.

Cette caractéristique de l'invention diffère totalement de ce que l'on connaît de la technique antérieure relative aux circuits imprimés classiques à pistes de cuivre sur les deux faces d'un support rigide et épais en verre époxy. Dans cette technique antérieure, les deux réseaux sont reliés entre eux par des trous »métallisés« du support (voir, par exemple, le document FR-A-2 402 379). Ces trous sont percés dans le support aux endroits voulus, après fabrication complète des deux réseaux conducteurs du circuit, puis leur paroi cylindrique interne est revêtue d'un film métallique conducteur par galvanoplastie, qui est un procédé long et coûteux, ce qui augmente encore le prix de revient d'un tel circuit imprimé.

Au contraire, selon l'invention, les connexions entre les deux réseaux sont formées en même temps que les réseaux conducteurs, en une seule opération et sans reprise du circuit pour un traitement complémentaire.

L'invention concerne également un circuit imprimé multicouches, comprenant plusieurs réseaux conducteurs croisés ou superposés, électriquement isolés les uns des autres à l'exception de certains points d'interconnexion caractérisé en ce qu'il comprend un circuit imprimé dont le support est pourvu sur ses deux faces d'un réseau conducteur formé par dépôt sérigraphique d'encre(s) conductrice(s), et en ce qu'au moins une face de ce circuit imprimé est revêtue d'une feuille ou d'un film de matière diélectrique présentant une face extérieure qui comporte un réseau conducteur formé par dépôt sérigraphique d'encre(s) conductrice(s), et des trous de connexion formés à travers ladite feuille ou ledit film et dont les parois sont recouvertes au moins partiellement d'une couche d'encre conductrice.

Selon une autre caractéristique de l'invention, ce circuit imprimé multi-couches comprend un empilement des dites feuilles ou films de matière diélectrique, dont chacune comprend sur une face un réseau conducteur du type précité et des trous de liaison à parois recouvertes au moins partiellement d'encre conductrice.

Un tel circuit imprimé multi-couches peut avoir une épaisseur comprise entre 1 et 2 mm par exemple, il peut être parfaitement souple et comprendre un grand nombre de réseaux conducteurs croisés ou superposés, ce nombre étant compris par exemple entre 3 et 15.

L'invention propose également un procédé de fabrication d'un circuit imprimé, caractérisé en ce qu'il consiste à former des trous dans un support plan de matière diélectrique en des points prédéterminés, à déposer par sérigraphie de l'encre conductrice sur ledit support en formant sur chacune de ses faces un réseau conducteur et en revêtant au moins partiellement les parois desdits trous d'une couche d'encre conductrice, et à polymériser ensuite l'encre par chauffage.

Selon d'autres caractéristiques de l'invention, le procédé consiste à déposer par sérigraphie l'encre conductrice simultanément sur les deux faces du support, ou bient à déposer par sérigraphie un premier réseau d'encre conductrice sur une première face du support, à polymériser l'encre par chauffage, à déposer ensuite par sérigraphie sur la second face du support un second réseau d'encre conductrice et à polymériser par chauffage.

Pour la fabrication d'un circuit imprimé multi-couches, le procédé consiste ensuite à fixer sur une face du circuit préalablement obtenu une feuille ou un film de matière diélectrique percé de trous en des points prédéterminés, de façon que ces trous débouchent sur des parties conductrices dudit circuit, à déposer par sérigraphie sur la face extérieure de ladite feuille ou film une couche d'encre conductrice, de manière à former sur cette face un réseau conducteur et à recouvrir au moins partiellement les parois desdits trous d'encre conductrice, et à polymériser par chauffage l'encre ainsi déposée.

On peut répéter ensuite ces opérations pour obtenir un circuit imprimé multi-couches comprenant un empilement de feuilles ou de films de matière diélectrique comportant chacune sur une face un réseau conducteur d'encre polymérisée.

Dans la description qui suit, faite à titre d'exemple, on se réfère aux dessins annexés, dans lesquels;

la figure 1 est une vue agrandie en perspective d'une partie d'un circuit imprimé selon la technique antérieure;

la figure 2 est une vue en coupe d'une partie de ce circuit;

la figure 2A est une vue agrandie du détail encerclé en II — A en figure 2;

la figure 3 est une vue schématique agrandie, en perspective, d'une partie d'un circuit imprimé selon l'invention;

la figure 4 est une vue en coupe d'une partie du circuit de la figure 3;

la figure 5 représente schématiquement, sous forme de blocs, les étapes d'un procédé de fabrication d'un circuit imprimé selon l'invention;

la figure 6 représente schématiquement, sous forme de blocs, les étapes supplémentaires de fabrication d'un circuit imprimé multi-couches; et

la figure 7 est une vue en coupe d'un circuit imprimé multi-couches selon l'invention.

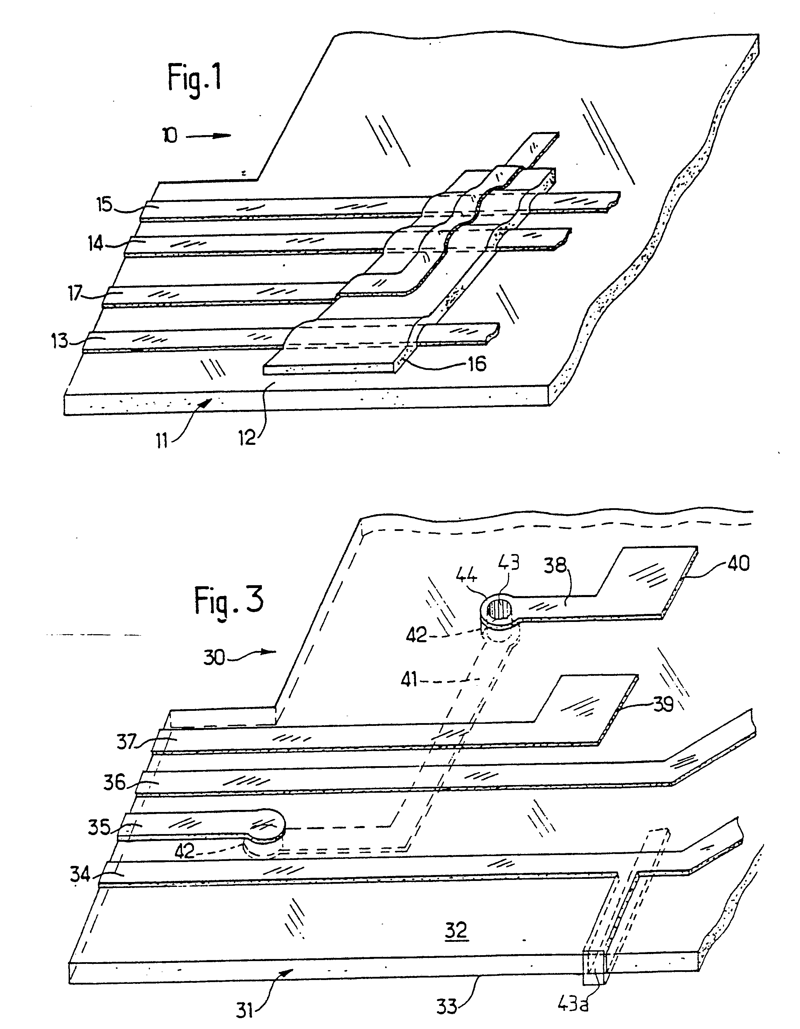

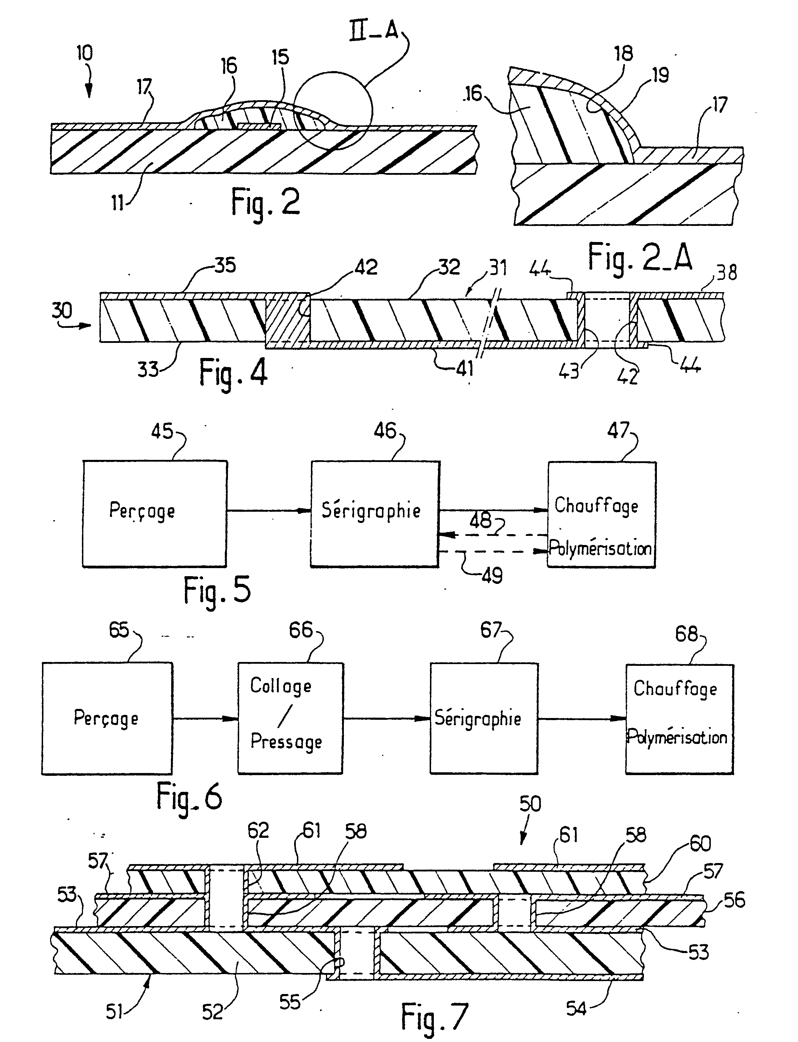

On se réfère tout d'abord aux figures 1, 2 et 2A qui représentent un circuit imprimé selon la technique antérieure.

Ce circuit imprimé 10 comprend un support plan 11 de matière diélectrique qui peut être rigide et épais, mais qui est avantageusement mince et souple, tel qu'un film de polyester d'une épaisseur de 0,1 mm environ par exemple. Sur la face supérieure 12 du support 11 sont formées des premières pistes conductrices 13, 14 et 15, par dépôt par sérigraphie d'une encre conductrice qui est ensuite polymérisée par chauffage.

On dépose ensuite par sérigraphie, sur certaines parties de la face supérieure 12 du support 11 et des pistes conductrices 13, 14 et 15, une couche 16 d'encre isolante ou diélectrique qui est ensuite polymérisée par chauffage. Cette couche isolante 16 a une épaisseur plus importante que celle des pistes conductrices 13, 14 et 15.

De nouvelles pistes conductrices 17 sont ensuite formées comme précédemment sur la face 12 du support 11, sur la couche 16 d'encre isolante et également sur certaines parties des premières pistes conductrices 13, 14 ou 15 aux endroits où l'on veut obtenir des connexions électriques entre le premier réseau conducteur formé par les pistes 13, 14 et 15 et le second réseau conducteur formé par les pistes conductrices 17. A titre d'exemple, on précise que les pistes conductrices ont une largeur d'1mm environ, une épaisseur comprise entre 20 et 30 microns et que les bandes 16 d'encre isolante ont une épaisseur et une largeur qui sont plusieurs fois supérieures à celles des pistes conductrices.

La figure 2 est une vue en coupe du circuit imprimé 10 dans la zone où une piste conductrice 17 du second réseau croise une piste conductrice 15 du premier réseau en étant isolée de celle-ci par la bande 16 d'encre diélectrique. Les bords de cette bande 16 forment, sur la surface supérieure 12 du support 11, des ressauts ou saillies 18, et l'épaisseur de la piste conductrice 17 déposée sur ces saillies est beaucoup plus faible qu'aux endroits où elle est déposée sur une partie plane, en raison de la fluidité de l'encre conductrice.

On a constaté la formation de criques et/ou de micro-fissures dans cette zone 19 d'épaisseur faible de la piste conductrice 17.

Les inconvénients essentiels de ce circuit imprimé de la technique antérieure ont été indiqués plus haut. On rappellera seulement que les particules conductrices (par exemple d'argent) contenues dans les pistes conductrices ont tendance à migrer à travers la couche 16 d'encre diélectrique et établissent des courts-circuits entre les deux réseaux conducteurs. La couche 16 devient cassante après chauffage, et sa rupture entraîne la rupture des pistes conductrices qu'elle recouvre. De plus, les encres diélectriques et conductrices sont peu compatibles entre elles, et les pistes conductrices 17 du second réseau conducteur adhèrent mal aux bandes d'encre diélectrique. Pour cette raison, on est amené souvent à déposer, sur une partie d'une piste conductrice 17 déposée sur une couche d'encre isolante 16, une nouvelle couche d'encre isolante pour tenter de consolider l'ensemble.

Le procédé de fabrication d'un tel circuit imprimé 10 est relativement long et nécessite quatre écrans de sérigraphie utilisés respectivement pour déposer les pistes conductrices 13, 14 et 15 du premier réseau conducteur, pour déposer les bandes 16 d'encre isolante, pour déposer les pistes conductrices 17 du second réseau conducteur, et pour déposer une nouvelle couche d'encre isolante 16 sur certaines parties des pistes de second réseau et des premières couches isolantes. De plus, une nouvelle couche d'encre ne peut être déposée qu'après polymérisation de la couche d'encre précédemment déposée, ce qui entraîne une succession d'opérations de dépôt par sérigraphie et de chauffage pour polymérisation.

L'invention a pour but essentiel d'éviter tous ces inconvénients et de plus d'améliorer de façon très importante la qualité des circuits imprimés.

On se réfère maintenant aux figures 3 et 4, qui représentent un circuit imprimé selon l'invention.

Ce circuit imprimé 30 comprend un support plan 31 de matière diélectrique, tel qu'un film de polyester d'une épaisseur comprise entre 15 et 1500 microns, par exemple entre 80 et 100 microns. Un tel film est connu commercialement sous le nom de »MYLAR«. Les deux faces 32 et 33 du support 31 comprennent chacune un réseau conducteur formé par dépôt par sérigraphie d'encre conducrice qui est ensuite polymérisée par chauffage. Le réseau conducteur formé sur la face supérieure 32 du support 31 comprend des pistes conductrices 34, 35, 36, 37, 38 etc., et des plots de contact 39 et 40 reliés aux pistes 37 et 38 respectivement.

Le réseau conducteur formé sur la face inférieure 33 du support 31 comprend des pistes conductrices 41, dont une seule a été représentée en figure 3. Les connexions voulues entre les deux réseaux conducteurs sont établies au moyen de trous 42 du support 31, qui débouchent à leur extrémité supérieure sur une piste conductrice du premier réseau et à leur extrémité inférieure sur une piste conductrice du second réseau. Un trou 42 peut être, par exemple, rempli au moins partiellement, d'encre conductrice polymérisée. Dans l'exemple représenté en figure 3, une extrémité de la piste 41 du réseau conducteur inférieur est reliée par une telle connexion à la piste 35 du réseau conducteur supérieur, et l'autre extrémité de la piste 41 est reliée à la piste 38 du réseau conducteur supérieur par un film 43 d'encre conductrice revêtant au moins partiellement la paroi du trou 42 et se terminant à chaque extrémité du trou par une plage annulaire 44 sur la face correspondante du support 31, cette plage ayant un diamètre extérieur supérieur au diamètre du trou 42.

Une caractéristique importante de l'invention est que l'épaisseur du film 43 d'encre conductrice revêtant la paroi d'un trou est égale à l'épaisseur de la piste 41 ou 38 d'encre conductrice formée sur la face 33 ou 32 du support. On obtient ainsi, après polymérisation de l'encre, une connexion parfaitement homogène et exempte de défauts (tels que criques, fissures, variations d'épaisseur aux extrémités des trous), ce qui est essentiel lorsque le support est un film souple de matière plastique ayant une épaisseur faible, par exemple de 80 à 100 microns. Cette qualité de la connexion à travers le support est due au procédé selon l'invention qui consiste à réaliser les pistes et les connexions à travers le support en une seule opération. Lorsque les trous sont remplis d'encre conductrice, ils contiennent une quantité d'encre relativement importante susceptible de produire des retraits à la polymérisation, d'où les risques de criques sur les bords des trous.

Les trous 42 peuvent être à section circulaire comme représenté, auquel cas leur paroi cylindrique est revêtue complètement d'un film d'encre conductrice, ou bien à section carrée ou rectangulaire, auqeul cas une seule face plane du trou est revêtue d'encre ou bien deux faces opposées.

Une liaison entre deux pistes conductrices formées chacune sur une face différente du support peut également être réalisée sur la tranche du support, comme indiqué en 43a en figure 3.

Une patte en saillie du support, telle que celle de la figure 3 portant les extrémités des pistes 34, 35, 36, 37, peut être utilisée comme partie mâle d'un connecteur standard. Lorsque le support est un film souple de matière plastique, cette patte peut être repliée autour d'une patte correspondante d'un support rigide présentant l'épaisseur voulue.

Si on le désire, les plots ou plages de contact 39, 40, ainsi que les extrémités des pistes 34 – 37 qui se terminent au bord 43 du support 41 et qui servent de pistes de liaison avec un connecteur, peuvent être formées par une encre conductrice différente de l'encre utilisée pour les pistes conductrices et qui présente, après polymérisation, une dureté ou une résistance mécanique supérieure à celle des pistes conductrices. A titre d'exemple non limitatif, on indique que les plots ou plages de contact peuvent être formés avec l'encre fournie par la Société EPOTECNY sous la référence H 20 F-1, et que les pistes conductrices peuvent être formées avec l'encre fournie par le COMPTOIR LYON ALEMAND LOUYOT sous la référence V F 5, ou par la Société DUPONT DE NEMOURS sous la référence 40 49. On peut également, selon d'invention, utiliser des encres sérigraphiques résistives ou conductrices, disponibles dans le commerce, pour former par sérigraphie un réseau conducteur imprimé contenant des résistances, des condensateurs ou des inductances.

Sur un circuit selon l'invention, tel que celui de la figure 3, il est possible de souder des composants tels que des résistances, des condensateurs, des inductances, des transistors, des circuits intégrés, etc.

Dans une variante de réalisation, le support souple 31, constitué par un film de polyester par exemple, peut être remplacé par une feuille plus épaisse de matière diélectrique, telle qu'une feuille de verre époxy par exemple. On obtient ainsi un circuit imprimé rigide ou semi-rigide en fonctioin de l'épaisseur du support.

Dans tous les cas, le diamètre des trous 42 de connexion entre les deux réseaux conducteurs du circuit doit être déterminé du façon que les parois des trous soient partiellement ou totalement recouvertes d'encre conductrice lorsque les réseaux conducteurs sont formés sur le support par dépôt par sérigraphie d'encre conductrice. Ce diamètre est fonction de la viscosité de l'encre utilisée et de l'épaisseur du support. On a constaté que, pour la plupart des encres conductrices, et quand le support a une épaisseur d'environ 80 à 100 microns, les meilleurs résultats étaient obtenus avec des trous d'un diamètre d'environ 0,8 mm au minimum.

On se réfère maintenant à la figure 5 qui représente schématiquement les différentes étapes d'un procédé de fabrication d'un circuit imprimé selon l'invention.

La première étape 45 consiste en un perçage du support 31 de façon à y former des trous d'une taille prédéterminée aux endroits où l'on veut assurer des connexions entre les deux réseaux conducteurs. L'étape suivante 46 consiste à déposer sur chaque face 32, 33 du support 31 un réseau d'encre conductrice, au moyen de deux écrans de sérigraphie contenant de l'encre. Cette technique d'impression ou de dépôt par sérigraphie est très bien connue et ne sera pas décrite plus en détail. Les parois des trous 42 percés dans le support sont revêtues, au moins partiellement, d'un film d'encre conductrice en même temps que les réseaux conducteurs sont formés sur les deux faces du support 31. L'étape suivante 47 consiste à soumettre le support, dont les deux faces comportent un réseau d'encre conductrice, à un chauffage pour polymériser l'encre. Ce chauffage est réalisé en général dans un four, par exemple à rayonnement infrarouge ou ultraviolet, à une température de 150°C pendant une durée de 5 à 10 minutes.

Le circuit imprimé est alors terminé et peut être utilisé. Eventuellement, si on le désire, l'un et/ou l'autre des réseaux conducteurs peuvent être recouverts d'un film de matière diélectrique telle qu'un vernis isolant, de façon classique.

Dans une variante de ce procédé, après l'étape 45 de perçage du support, on dépose par sérigraphie un réseau d'encre conductrice sur une seule face du support 31, puis on soumet le circuit à un chauffage pour polymériser l'encre, de la même façon que précédemment. Ensuite, comme indiqué par la flèche en trait pointillé 48, on dépose sur l'autre face du support un autre réseau d'encre conductrice que l'on soumet ensuite, comme indiqué par la flèche en trait pointillé 49, à un nouveau chauffage pour polymériser cette encre.

Les plots ou plages de contact 39, 40 peuvent être formés en même temps que les pistes conductrices du réseau conducteur correspondant, c'est-à-dire avec la même encre conductrice, ou bien ils peuvent être formés de façon séparée par un dépôt supplémentaire par sérigraphie d'une encre conductrice qui, après polymérisation, présente une plus grande dureté ou une plus grande résistance mécanique que les encres des pistes conductrices.

Dans une autre variante de réalisation de l'invention, on utilise un support souple, semi-rigide ou rigide, dont les deux faces comportent déjà un réseau conducteur, par exemple en cuivre. Pour cela, on part, comme dans la technique classique, d'un support dont les deux faces sont métallisées par exemple par un film de cuivre, on forme un réseau conducteur sur chacune de ces faces par la technique classique de photogravure et on perce des trous dans le support aux endroits où l'on veut établir des connexions entre les deux réseaux conducteurs. Ensuite, il suffit de déposer par sérigraphie de l'encre conductrice dans les zones comprenant les trous, sur une ou sur les deux faces du support, et de soumettre l'ensemble à un chauffage pour polymériser l'encre. Cette technique peut également être utilisée pour former des plages ou des plots de contact sur les réseaux conducteurs en cuivre. On peut utiliser pour cela une encre conductrice contenant des particules d'argent qui, après polymérisation de l'encre, vont former des plages de contact sur les pistes en cuivre ou reliées aux pistes en cuivre.

La figure 6 représente schématiquement une autre variante du procédé selon l'invention, pour la fabrication d'un circuit imprimé multi-couches représenté en figure 7. Ce circuit 50 est réalisé par exemple à partir d'un circuit imprimé 51 obtenu par le procédé de la figure 5. Le circuit 51 comprend donc un support 52, tel qu'un film de polyester d'une épaisseur de 80 à 100 microns, dont les deux faces comprennent chacune un réseau conducteur comprenant des pistes conductrices 53 et 54 respectivement et des connexions entre les deux réseaux formées par des trous 55 traversant le support 52 et à parois revêtues, au moins partiellement, d'encre conductrice polymérisée. Sur la face supérieure du support 52 et sur le réseau conducteur supérieur comprenant les pistes 53, est fixé un support 56 tel qu'une feuille ou un film de polyester, ayant une épaisseur comprise entre 15 et 100 microns et qui est par exemple inférieure à l'épaisseur du support 52 du circuit 51. Sur la face supérieure de cette feuille 56 est formé un réseau conducteur comprenant des pistes conductrices 57. Des trous 58 formés à travers la feuille 56 et pourvus d'un film d'encre polymérisée, assurent les connexions voulues entre les pistes conductrices 57 formées sur la face supérieure de la feuille 56 et les pistes conductrices 53 du réseau formé sur la face supérieure du circuit imprimé 51. Un autre film ou feuille 60 de matière diélectrique, par exemple de polyester, qui peut être identique au film ou à la feuille 56, est ensuite fixé sur la face supérieure de la feuille 56 et sur le réseau conducteur de celle-ci, et comporte luimême, sur sa face supérieure, un réseau conducteur comprenant des pistes conductrices 61. Des trous 62 formés à travers le film 60 et pourvus d'un film d'encre conductrice polymérisée assurent les connexions voulues entre les pistes conductrices 61 et les pistes conductrices 57. Un trou 62 du film 60 peut être verticalement aligné avec un trou 58 de la feuille 56, et dans ce cas une connexion est établie entre les pistes 61, 57 et 53.

On peut ainsi réaliser un circuit imprimé multi-couches, par empilement de films ou de feuilles 56, 60, . . . comportant chacun un réseau conducteur et des trous de connexion entre ces réseaux conducteurs.

Le procédé de fabrication d'un tel circuit imprimé multi-couches, par exemple à partir d'un circuit imprimé 51 obtenu par le procédé de la figure 5, consiste, comme représenté en figure 6, en une première étape 65 de perçage de la feuille ou du film 56 de matière diélectrique. L'étape suivante 66 consiste à fixer cette feuille en ce film sur une face du circuit imprimé 51, par exemple par collage ou pressage à chaud. L'étape suivante 67 consiste à former, par dépôt par sérigraphie d'encre conductrice, un réseau conducteur 57 sur la face supérieure ou libre de la feuille ou du film 56. L'étape suivante 68 est une opération de chauffage pour polymériser l'encre conductrice déposée. On répète ensuite ces opérations pour la feuille ou le film 60.

L'invention présente de très nombreux avantages par rapport aux techniques antérieures:

— le coût d'un circuit imprimé selon l'invention est environ 80 fois moins élevé que celui d'un circuit imprimé classique à pistes conductrices en cuivre sur un support de verre époxy, et trois à quatre fois moins élevé que celui d'un circuit tel que celui des figures 1 et 2.

— Le taux de rebut dans la fabrication des circuits imprimés selon l'invention est nul, en raison des possibilités de retouche des réseaux conducteurs formés par dépôt par sérigraphie d'encre conductrice polymérisée ensuite, alors que le taux de rebut dans la fabrication des circuits imprimés tels que ceux des figures 1 et 2 est de l'ordre de 25 à 30% au minimum.

— L'isolation entre les deux réseaux conducteurs est garantie par l'épaisseur du support.

— Les réseaux conducteurs sont déposés sur des surfaces planes.

— On n'utilise, dans le procédé de la figure 5, que deux écrans sérigraphiques au lieu de trois ou quatre dans le procédé de fabrication des circuits des figures 1 et 2.

— On peut réaliser un circuit imprimé selon l'invention en un seul passage entre les écrans sérigraphiques, au lieu de trous ou quatre passages dans la technique antérieure.

— Selon le procédé de la figure 5, on passe le circuit une seule fois dans un four, pour la polymérisation de l'encre, alors que le nombre de passages dans un four est de trois ou quatre dans la technique antérieure.

— La fiabilité d'un circuit imprimé selon l'invention est très supérieure à celui d'un circuit imprimé du type représenté dans les figures 1 et 2, car les pistes d'encre conductrice et les connexions ne se brisent pas, même à la suite d'un pliage marqué de support. Le dépôt simultané des encres conductrices sur les deux faces du support, ou les deux dépôts successifs d'encre conductrice d'abord sur une face puis sur l'autre du support, assurent dans tous les cas un bon revêtement de parois des trous de connexions par une couche uniforme d'une seule encre qui est ensuite polymérisée par chauffage, ce qui a pour effet de réaliser une connexion homogène et dépourvue de tension mécanique interne (ce qui évite les gradients de dilatation, les apparitions de microfissures, etc.).

— L'épaisseur du film d'encre conductrice revêtant les parois des trous de liaison est sensiblement égale à celle des pistes conductrices formées sur les deux faces du support, ce qui évite les risques de criques ou de fissures aux bords des trous après polymérisation.

— L'invention permet de réaliser des circuits imprimés à au moins deux réseaux conducteurs croisés ou superposés, qui sont souples, semi-rigides ou rigides, en fonction de la nature et de l'épaisseur du support de matière diélectrique.

— L'invention permet également de réaliser des circuits imprimés à partir de feuilles de polyester dont les deux faces sont métallisées, par exemple par un film de cuivre, que l'on traite par photogravure pour former des réseaux conducteurs sur les deux faces, et dans lesquels les connexions entre les deux réseaux sont établies au moyen de trous traversant le support et dont les parois sont revêtues, au moins partiellement, d'encre conductrice polymérisée.

## Revendications

1. Circuit imprimé, comprenant un support (31) diélectrique, deux réseaux électriquement conducteurs formés sur les deux faces du support, ces réseaux étant électriquement isolés l'un de l'autre par le support, et reliés l'un à l'autre à travers des trous (42) du support, caractérisé en ce que, lesdits réseaux comprenant chacun des pistes (35—38, 41) d'encre conductrice polymérisée qui sont formées sur le support (31), des connexions entre les réseaux sont établies par une couche mince (43), d'épaisseur uniforme, d'encre conductrice polymérisée déposée sur les parois des trous (42) précités.

2. Circuit selon la revendication 1, caractérisé en ce que ledit support (31) est un film ou une feuille souple, par exemple de polyester.

3. Circuit selon l'une des revendications précédentes, caractérisé en ce que les parois des trous (42) sont, au moins partiellement, recouvertes d'une couche (43) d'encre conductrice polymérisée ayant la même épaisseur que les pistes (35—38, 41) d'encre conductrice formées sur les deux faces du support.

4. Circuit selon l'une des revendications 1 à 3, caractérisé en ce que lesdits réseaux et lesdites connexions sont formés par dépôt par sérigraphie d'encre conductrice polymérisée ensuite par chauffage.

5. Circuit selon l'une des revendications précédentes, caractérisé en ce que certaines connexions entre les réseaux sont formées par des pistes (43a) d'encre conductrice déposées sur la tranche du support (31), perpendiculairement à celui-ci.

6. Circuit selon l'une des revendications précédentes, caractérisé en ce qu'au moins un des réseaux conducteurs est revêtu, au moins sur une majeure partie, d'un film très mince de matière diélectrique, telle qu'un vernis isolant.

7. Circuit imprimé multi-couches, comprenant plusieurs réseaux conducteurs croisés ou superposés, électriquement isolés les uns des autres à l'exception de certains points d'interconnexion, caractérisé en ce qu'il comprend un circuit imprimé (51) selon l'une des revendications précédentes, dont au moins une face est revêtue d'une feuille (56) de matière diélectrique présentant une face extérieure qui comporte un réseau conducteur (57) formé par dépôt par serigraphie d'encre conductrice et des trous (58) formés à travers ladite feuille (56) et ayant des parois recouvertes au moins partiellement d'une couche mince d'encre conductrice pour relier chacun une zone conductrice dudit réseau (57) à une zone conductrice d'un réseau (58) formé sur ladite face du circuit imprimé (51).

8. Circuit selon la revendication 7, caractérisé en ce que ladite face extérieure de la feuille (56) de matière diélectrique est elle-même revêtue d'une autre feuille (60) de matière diélectrique dont la fache extérieure comporte un réseau conducteur (61) formé par dépôt par sérigraphie d'encre conductrice et qui comporte des trous (62) à parois au moins partiellement recouvertes d'encre conductrice assurant des liaisons entre les réseaux conducteurs (57, 61) des deux feuilles (56, 60).

9. Circuit selon la revendication 7 ou 8, caractérisé en ce qu'il comprend un empilement desdites feuilles (56, 60) de matière diélectrique, dont chacune comprend sur une face un réseau conducteur (57, 61) du type précité et des trous (58, 62) de liaison à parois au moins partiellement recouvertes d'encre conductrice.

10. Circuit selon la revendication 9, caractérisé en ce que certains trous (58, 62) desdites feuilles (56, 60) sont alignés et forment une connexion entre plusieurs conducteurs (53, 57, 61).

11. Procédé de fabrication d'un circuit imprimé selon l'une des revendications 1 à 6, consistant à former des trous (42) dans un support (31) de matière diélectrique en des points prédéterminés, et à déposer par sérigraphie de l'encre conductrice sur ledit support (31) pour former sur chacune de ses faces un réseau conducteur (35—38, 41) caractérisé en ce qu'il consiste à établir des liaisons entre les réseaux par recouvrement au moins partiel des parois des trous (42) par une couche mince (43) d'encre conductrice, et à polymériser l'encre par chauffage.

12. Procédé selon la revendication 11, caractérisé en ce qu'il consiste à déposer par sérigraphie l'encre conductrice simultanément sur les deux faces (32, 33) du support (31) et sur les parois des trous (42).

13. Procédé selon la revendication 11, caractérisé en ce qu'il consiste à déposer par sérigraphie un premier réseau d'encre conductrice sur une première face du support (31), à polymériser d'encre par chauffage, à déposer ensuite sur la seconde face du support (31) un second réseau d'encre conductrice, et à le polymériser par chauffage.

14. Procédé selon l'une des revendications 11 à 13, pour la fabrication d'un circuit imprimé multi-couches (50), caractérisé en ce qu'il consiste ensuite à fixer, sur une face du circuit (51) obtenu, une feuille (56) de matière diélectrique percèe de trous (58) en des points prédéterminés de façon que ces trous débouchent sur des parties conductrices (53) dudit circuit (51), à déposer par sérigraphie sur la face extérieure de ladite feuille (56) une couche d'encre conductrice en formant sur cette face un réseau conducteur (57) et en recouvrant, au moins partiellement, les parois desdits trous (58) d'encre conductrice, et à polymériser par chauffage l'encre ainsi déposée.

15. Procédé selon la revendication 14, caractérisé en ce qu'il consiste à répéter ces opérations pour obtenir un circuit imprimé multi-couches (50), comprenant un empilement de feuilles (56, 60) de matière diélectrique comportant chacune sur une face un réseau conducteur (57, 61) d'encre polymérisée.

## Patentansprüche

1. Gedruckte Schaltung, umfassend einen dielektrischen Träger (31) und zwei auf den beiden Seiten des Trägers ausgebildete elektrische Leiterbahnnetze, die durch den Träger elektrisch voneinander isoliert und durch Löcher (42) in dem Träger hindurch miteinander verbunden sind, dadurch gekennzeichnet, daß die Leiterbahnnetze jeweils auf dem Träger (31) ausgebildete, aus einer leitfähigen polymerisierten Tinte bestehende Leiterbahnen (35 bis 38, 41) umfassen, wobei die Verbindungen zwischen den Leiterbahnnetzen durch eine dünne Schicht (43) gleichförmiger Dicke von leitfähiger polymerisierter Tinte hergestellt sind, die auf die Wände der genannten Löcher (42) aufgebracht sind.

2. Gedruckte Schaltung nach Anspruch 1, dadurch gekennzeichnet, daß der genannte Träger (31) von einem Film oder einer weichen Folie, beispielsweise aus Polyester, gebildet ist.

3. Gedruckte Schaltung nach einem der vorangegangenen Ansprüche, dadurch gekennzeichnet, daß die Wände der Löcher (42) zumindest teilweise mit einer Schicht (43) einer leitfähigen polymerisierten Tinte bedeckt sind, welche die gleiche Dicke wie die Leiterbahnen (35 bis 38, 41) aus leitfähiger Tinte besitzt, die auf den beiden Seiten des Trägers ausgebildet sind.

4. Gedruckte Schaltung nach einem der Ansprüche 1 bis 3, dadurch gekennzeichnet, daß die genannten Leiterbahnnetze und die genannten Verbindungen durch Aufbringen einer leitfähigen Tinte mittels Siebdruck und durch anschließende Polymerisation der Tinte durch Wärmezufuhr hergestellt sind.

5. Gedruckte Schaltung nach einem der vorangegangenen Ansprüche, dadurch gekennzeichnet, daß bestimmte Verbindungen zwischen den Leiterbahnnetzen durch Leiterbahnen (43a) aus leitfähiger Tinte hergestellt sind, die auf der senkrecht zur Trägerebene gerichteten Kantfläche des Trägers (31) aufgebracht sind.

6. Gedruckte Schaltung nach einem der vorangegangenen Ansprüche, dadurch gekennzeichnet, daß zumindest eines der Leiterbahnnetze zumindest auf einem größeren Abschnitt mit einem sehr dünnen Film eines dielektrischen Materials wie beispielsweise eines Isolierlackes bedeckt ist.

7. Mehrschichtige gedruckte Schaltung, umfassend mehrere sich kreuzende oder übereinander gelagerte Leiterbahnnetze, die mit Ausnahme gewisser Verbindungspunkte elektrisch voneinander isoliert sind, dadurch gekennzeichnet, daß sie eine gedruckte Schaltung (51) nach einem der vorangegangenen Ansprüche umfaßt, von der mindestens eine Seite mit einer Folie (56) aus einem dielektrischen Material bedeckt ist, die wiederum auf einer Außenseite ein durch Siebdruck mittels einer leitfähigen Tinte hergestelltes Leiterbahnnetz (57) und die genannte Folie (56) durchsetzende Löcher (58) aufweist, deren Wände zumindest teilweise mit einer dünnen Schicht einer leitfähigen Tinte bedeckt sind, um jede leitfähige Zone des Leiterbahnnetzes (57) mit einer leitfähigen Zone eines Leiterbahnnetzes (53) auf der genannten Seite der gedruckten Schaltung (51) zu verbinden.

8. Gedruckte Schaltung nach Anspruch 7, dadurch gekennzeichnet, daß die genannte Außenseite der Folie (56) aus dielektrischem Material selbst mit eine weiteren Folie (60) aus dielektrischem Material bedeckt ist, deren Außenseite ein durch Siebdruck mittels einer leitfähigen Tinte aufgebrachtes Leiterbahnnetz (61) trägt und die Löcher (62) mit Wänden aufweist, die zumindest teilweise mit einer leitfähigen Tinte bedeckt sind und dadurch Verbindungen zwischen den Leiterbahnnetzen (57, 61) der beiden Folien (56, 60) herstellen.

9. Gedruckte Schaltung nach Anspruch 7 oder 8, dadurch gekennzeichnet, daß sei einen Stapel der genannten Folien (56, 60) aus dielektrischem Material umfaßt, von denen jede auf einer Fläche ein Leiterbahnnetz (57, 61) der genannten Art sowie Verbindungslöcher (58, 62) mit zumindest teilweise mit einer leitfähigen Tinte bedeckten Wänden aufweist.

10. Gedruckte Schaltung nach Anspruch 9, dadurch gekennzeichnet, daß bestimmte Löcher (58, 62) der genannten Folie (56, 60) miteinander fluchten und eine Verbindung zwischen mehreren Leiterbahnnetzen (53, 57, 61) bilden.

11. Verfahren zur Herstellung einer gedruckten Schaltung nach einem der Ansprüche 1 bis 6, wobei in einem aus einem dielektrischen Material bestehende Träger (31) an vorbestimmten Punkten desselben Löcher (42) gebildet werden und wobei mittels Siebdruck auf den genannten Träger (31) leitfähige Tinte aufgebracht wird, um auf jeder Seite des Trägers ein Leiterbahnnetz (35 bis 38, 41) auszubilden, dadurch gekennzeichnet, daß Verbindungen zwischen den Leiterbahnnetzen dadurch hergestellt werden, daß die Wände der Löcher (42) zumindest teilweise mit einer dünnen Schicht (43) aus leitfähiger Tinte bedeckt werden und diese durch Erwärmung polymerisiert wird.

12. Verfahren nach Anspruch 11, dadurch gekennzeichnet, daß die leitfähige Tinte durch Siebdruck gleichzeitig auf die beiden Seiten (32, 33) des Trägers (31) und auf die Wände der Löcher (42) aufgetragen wird.

13. Verfahren nach Anspruch 11, dadurch gekennzeichnet, daß auf eine erste Fläche des Trägers (31) mittels Siebdruck ein erstes Leiterbahnnetz aus leitfähiger Tinte aufgetragen wird, daß die Tinte durch Erwärmen polymerisiert wird, daß anschließend auf die zweite Seite des Trägers (31) ein Leiterbahnnetz aus leitfähiger Tinte aufgetragen wird und daß diese durch Erwärmen polymerisiert wird.

14. Verfahren nach einem der Ansprüche 11 bis 13, zur Herstellung einer mehrschichtigen gedruckten Schaltung (50), dadurch gekennzeichnet, daß anschließend auf einer Seite der erhaltenen Schaltung (51) eine Folie (56) aus dielektrischem Material befestigt wird, die an vorbestimmten Stellen mit Löchern (58) derart versehen ist, daß diese Löcher an leitfähigen Abschnitten (53) der genannten Schaltung (51) münden, daß durch Siebdruck auf der Außenseite der genannten Folie (56) eine Schicht einer leitfähigen Tinte aufgebracht und damit auf dieser Seite ein Leiterbahnnetz (57) gebildet und zumindest teilweise die Wände der genannten Löcher (58) mit leitfähiger Tinte bedeckt werden und daß die so aufgebrachte Tinte anschließend durch Wärmezufuhr polymerisiert wird.

15. Verfahren nach Anspruch 14, dadurch gekennzeichnet, daß diese Verfahrensschritte wiederholt werden, um eine mehrschichtige gedruckte Schaltung (50) zu erhalten, die einen Stapel von Folien (56, 60) aus dielektrischem Material umfaßt, die jeweils auf einer Seite ein Leiterbahnnetz (57, 61) aus polymerisierter Tinte tragen.

## Claims

1. A printed circuit comprising a dielectric support (31), two crossed electrically conductive networks carried by the two faces of the support, said networks being electrically insulated from each other by the support, and being connected to each other by holes (42) through the support, characterized in that each network comprises tracks (35—38, 41) of polymerized conductor ink which are formed on the support (30), each connection between the networks being established by a thin layer (43) of uniform thickness of conductive polymerized ink deposited on the wall of one of the above-mentioned holes (42).

2. A circuit according to claim 1, characterized in that said support (31) is a flexible film or sheet, eg. of polyester.

3. A circuit according to any preceding claim, characterized in that the wall of the holes (42) are at least partially covered in a layer (43) of polymerized ink having the same thickness as the tracks (35—38, 41) of conductive ink formed on the two faces of the support.

4. A circuit according to any one of claims 1 to 3, characterized in that the said networks and the said connections are formed by silk screen deposition of conductive ink which is then polymerized by heating.

5. A circuit according to any preceding claim, characterized in that some of the connections between the networks are formed by tracks (43a) of conductor ink deposited over the edge (31) of the support, perpendicular thereto.

6. A circuit according to any preceding claim, characterized in that at least one of the conductor networks is covered, at least over a major portion thereof, by a very thin film of dielectric material, such as an insulating varnish.

7. A multi-layer printed circuit, comprising a plurality of crossed or superposed conductor networks which are electrically insulated from one another except at certain interconnection points, characterized in that it comprises a printed circuit (51) according to any one of the preceding claims, having at least one face clad with a sheet or film (56) of dielectric material having an outside face which has a conductor network (57) formed by silk screen deposition of conductor ink, and holes (58) formed through said sheet or said film (56) having walls at least partially covered in a thin layer of conductor ink, each connecting a conductive zone of said network (57) to a conductive zone of a network (58) formed on said face of the printed circuit (51).

8. A circuit according to claim 7, characterized in that said outside face of the sheet of film (56) of dielectric material is itself clad with another sheet or film (60) of dielectric material whose outside face includes a conductor network (61) formed by silk screen deposition of conductor ink, and which includes holes (62) having walls clad with conductor ink providing connections between the conductor networks (57, 61) of both sheets or films (56, 60).

9. A circuit according to claim 7 or 8, characterized in that it comprises a stack of said sheets or films (56, 60) of dielectric material, each having a conductor network (57, 61) of the above-mentioned type on one face, and each having connection holes (58, 62) with walls at least partially covered in conductor ink.

10. A circuit according to claim 9, characterized in that some of the holes (58, 62) through said sheets or films (56, 60) are aligned and form a connection between several networks of conductors (53, 57, 61).

11. A method of manufacturing a printed circuit according to any one of claims 1 to 6 consisting in forming holes (42) through a support (31) of dielectric material at predetermined points, and in silk screen depositing a conductor ink on said support (31) to form a conductor network (35—38, 41) on each of the faces of the support, characterized in that it consists in establishing links between the networks by at least partially covering the walls of the holes (42) in respective thin layers (43) of conductor ink, an in polymerizing the ink by heating.

12. A method according to claim 11, characterized in that it consists in simultaneous silk screen deposition of conductor ink on both faces (32, 33) of the support (31), and on the walls of the holes (42).

13. A method according to claim 11, characterized in that it consists in silk screen deposition of a first network of conductor ink on a first face of the support (31), in polymerizing the ink by heating, in then depositing a second network of conductor ink on the second face of the support (31), and in polymerizing it by heating.

14. A method according to any one of claims 11 to 13, for manufacturing a multi-layer printed circuit (50), characterized in that it consists in fixing a sheet or film (56) of dielectric material on a face (51) of the circuit obtained, said sheet or film (56) being pierced by holes (58) at predetermined points in such a manner that the holes open out in conductor portions (53) of said circuit (51), in silk screen depositing a layer of conductor ink on the outside face of said sheet or film (56) to form a conductor network (57) on said face and to cover, at least partially, the walls of said holes (58) in conductor ink, and in polymerizing the ink thus deposited by heating.

15. A method according to claim 14, characterized in that it consists in repeating said operations to obtain a multi-layer printed circuit (50), comprising a stack of sheets or films (56, 60) of dielectric material, each of which has a conductor network (57, 61) of polymerized ink on one face thereof.

Fig.1

Fig.3

Fig. 2

Fig. 2_A

Fig. 4

**Fig. 5**

| Perçage | Sérigraphie | Chauffage |
| --- | --- | --- |
| | | Polymérisation |

**Fig. 6**

| Perçage | Collage / Pressage | Sérigraphie | Chauffage |
| --- | --- | --- | --- |
| | | | Polymérisation |

Fig. 7